Europäisches Patentamt

(19) European Patent Office

Office européen des brevets

(11) Publication number : **0 430 428 A2**

# (12) EUROPEAN PATENT APPLICATION

(21) Application number : **90311648.1**

(22) Date of filing : **24.10.90**

(51) Int. Cl.⁵ : **H03M 13/12**

(30) Priority : **29.11.89 GB 8927006**

(43) Date of publication of application :
**05.06.91 Bulletin 91/23**

(84) Designated Contracting States :
**DE FR GB IT SE**

(71) Applicant : **TECHNOPHONE LIMITED**
**Ashwood House Pembroke Broadway**
**Camberley Surrey GU15 3SP (GB)**

(72) Inventor : **Ng, Samuel**
**40 Claremont Road**
**Bishopston Bristol, BS7 8DH (GB)**

(74) Representative : **Frain, Timothy John**
**Technophone Limited Intellectual Property**
**Manager Ashwood House Pembroke**
**Broadway**
**Camberley, Surrey GU15 3SP (GB)**

(54) **Data symbol estimation.**

(57)     A method of equalizing a digitised data signal transmitted as a sequence of data symbols. The received signal is generally distorted by transmission through a dispersive communications channel and the detected symbol **(D)** may differ from the expected symbol **(E)**. The received symbols can exist in a plurality of different states depending on the number of symbols in the data alphabet and the extent of intersymbol interference. An estimate of the data symbol is made based on the maximum likelihood of a particular state transition as represented by the so-called branch metric. In the present method a pseudo-Euclidean branch metric (b) is used which is calculated using exclusively additive arithmetic according to the formula

$$b = |d_r - e_r| + |d_i - e_i|$$

where $d_r$ and $d_i$ are the real and imaginary components respectively of the detected symbol **(D)** and $e_r$ and $e_i$ are the real and imaginary components respectively of the expected symbol **(E)**. By avoiding the need for a multiplier the power consumption is reduced. The implementation complexity is also reduced thus minimising the area of semiconductor needed for realization in IC form. A fully multiplier-less equalizer is also disclosed.

Fig. 3.

EP 0 430 428 A2

# DATA SYMBOL ESTIMATION

This invention relates to a method and apparatus for estimating a data symbol in a sequence of transmitted data symbols received over a communication channel and has particular, but not exclusive, application in the equalization of data transmitted over radio channels. In the present specification digitised signals are referred to as data.

The problem of intersymbol interference resulting from transmission of data on dispersive communication channels is known and an equalization process is effected on the received signal in order to estimate the individual data symbols which were originally transmitted. Various types of equalizer are know but of particular interest in the present context are so-called maximum likelihood (ML) detectors.

In the context of ML detection, a trellis diagram is commonly used to represent the progression of states with the passage of time. It is noted here that the number of states S is given by the equation $S = N^c$ where N is the number of symbols in the data alphabet used and C is the constraint length (ie. extent of intersymbol interference). Thus for a 2-symbol alphabet and a constraint length of 4 there are 16 possible states.

Furthermore, for the purpose of forward error correction, data may be convolutionally encoded before it is transmitted. (Forward error correction means that the data is corrected at the receiver without the need for retransmission). A Viterbi detector may also be used for decoding convolutionally encoded data.

The term 'node' is usually used to designate a particular state at a particular time on a trellis diagram.

The arc or path representing the transition between two states (nodes) adjacent in time is known as a 'branch' and the associated 'branch metric' is an indication of the likelihood of the particular transition occurring. The 'partial path metric' is the overall probability that a particular partial path to the left of the node under consideration represents the correct sequence of state transitions. The term 'partial path' is construed accordingly. This is the meaning of the terms partial path and partial path metric as they are used in the present specification, but the terms 'path' and 'path metric' are also used to convey the same meaning. The overall path i.e. the path between the beginning and the end of the trellis which has the maximum path metric is the maximum likelihood path which essentially represents the best estimate of the data symbols actually transmitted.

In theory a maximum likelihood (ML) or maximum a-posteriori (MAP) detector may be used wherein the branch metrics are calculated for every branch in the trellis diagram. The path metric for every path in the trellis diagram is then determined, and finally the path for which the overall path metric is a maximum is chosen. The sequence of symbols corresponding to this path is the estimate of the symbols actually transmitted. The difficulty with this approach is that the number of paths increases exponentially as the trellis diagram is traversed from left to right.

The Viterbi detector is a computationally more efficient version of a ML detector which exploits the special structure of the detector to achieve a complexity that grows linearly rather than exponentially along the trellis. Hence, a Viterbi detector has the advantage that it requires a constant computation rate per unit time. For each node, the Viterbi detector selects the path having the largest partial path metric, called the 'survivor path' for that node. All partial paths other than the survivor path are discarded because any other partial path has by definition a smaller partial path metric, and hence if it replaced the survivor path in any overall path, the path metric would be smaller.

At each stage of the trellis it is not known which node the optimal path must pass through and so it is necessary to retain one survivor path for each and every node. The symbol associated with the survivor path, called the 'survivor', and the associated path metric have to be stored in memory for each node at a stage representing a particular time in order for the algorithm to proceed to the next stage at time increment $t + 1$.

When the terminal node of the trellis has been reached it is possible to determine the unique path of maximum likelihood representing the estimation of the symbols actually transmitted. It is only at this stage that the estimated data symbols can be read off by effecting a "trace-back" along the identified maximum likelihood path.

The known Viterbi detector has the drawback that an appreciable time delay occurs between detection and output. There are two main factors contributing to this delay. Firstly there is the so-called "truncation length" which is the temporal length of the survivor information stored in memory and secondly there is the so-called "trace-back delay'" which is the time taken to process the survivor information, ie. the time between storing the survivor information in memory and outputting the estimated data decisions. The total time delay may typically amount to, say 70 bits which, by way of example, at a bit transmission rate of 270 kb/s would correspond to a significant time delay of 0.26 ms. This time lag is undesirable in data receivers generally, but is especially detrimental in the case of voice communication applications.

European patent application EP-A-0,302,330 relates to a method of evaluating metrics in which individual path decisions are made for each state by comparing the pair of 'opposing' path metrics, i.e. the path metrics associated respectively with two different symbol types [designated $M_A(x,k + 1)$ and $M_B(x,k + 1)$ in the present application]. For each state the first path metric [$M_A(x,k + 1)$] of the opposing pair is calculated by adding the current branch metric [$b(x,k + 1 \mid x_A,k)$] relating to a first symbol type [A] to the respective previous partial path metric [$M(x_A,k)$] and the second path metric [$M_B(x,k + 1)$] of the pair is calculated by adding the current opposed branch metric [$b(x,k + 1 \mid x_B,k)$], i.e. relating to a second symbol type [B], to the respective previous partial path metric [$M(x_B,k)$]. The two opposing path metrics are differenced [$M_A(x,k + 1) - M_B(x,k + 1)$] to yield a path decision for each state. Thus, in the case of sixteen states, sixteen path decisions (denoted DEC0, DEC1, ...DEC15 in EP-A-0,302,330) will be made. Although that patent specification is not explicit in this regard, it is assumed that these path decisions are all stored in memory for selection and read back at a subsequent trace-back stage in the conventional manner. Also, for each state the two opposing path metrics are compared and the minimum value (MSEL0, MSEL1, ...MSEL15) is selected for use as the previous partial path metric at the next transition stage of the trellis. A further stage (M-AND and PRE-MI) is provided for comparing all the minimum metrics (MSEL0, MSEL1, ...MSEL15) and selecting the overall minimum value (MMIN) which is subtracted as an offset from each of the minimum metric values (MSEL0, MSEL1, ...MSEL15) at each of the sixteen individual stages (viz. at subtractors SUB0, SUB1, ...SUB15) in a process which may effectively be regarded as normalization. Additionally, the maximum of all the sixteen minimum metric values may be determined. The maximum and minimum values of the complete set of minimum metrics (SEL0, SEL1, ...SEL15) may be differenced to provide a so-called differential metric which (as mentioned in passing in EP-A-0,302,330) may be used, for example, for synchronization or for phase ambiguity resolution during Viterbi decoding. However, it is noted that EP-A-0,302,330 is silent as to how the branch metrics per se are calculated.

A method of estimating the data symbols which is even more efficient than the known Viterbi method is disclosed and claimed in our co-pending European patent application No. —————— corresponding to UK patent application No. 8927005.2 (our ref : PAT 89014). This method also has the two-fold advantage that (i) a near-instantaneous decision of the estimated symbol can be made, and (ii) there is no need for memory storage. The method involves the following main steps :

1) Determine for each state at a given time increment k the respective partial path metric ($M_A$) in respect of the state transition corresponding to the transmission of a first symbol type (A). 2) Determine for each state at the same time increment k the respective partial path metric ($M_B$) in respect of the state transition corresponding to the transmission of a second symbol type (B). 3) Select the maximum value ($M_{Amax}$ and $M_{Bmax}$) of the first and second symbol type partial path metrics. 4) Difference the two maximum values at step 3 to yield an estimate of the transmitted data symbol.

All of the above symbol estimation techniques do of course require the calculation of branch metrics. As mentioned above, the branch metric is a measure of the probability or likelihood of a particular transition between states having occurred. In the present specification the notation $b(0,k + 1 \mid 0,k)$ is used to represent the branch metric between state 0 at time $k + 1$ and state 0 at the previous time increment k, as explained in more detail below.

In the case of Gaussian noise it is well known that the branch metric is proportional to $\mid D - E \mid^2$, where D is the detected or observed symbol and E is the expected symbol determined according to the channel input response. In fact this value is the square of the Euclidean distance between the observed and expected symbols. The shorter this Euclidean distance, the closer the observed symbol is in signal space to the expected symbol and hence the more likely the expected symbol is a true representation of the transmitted symbol.

By way of further explanation, a detected symbol is the sampled form of the signal actually detected at the receiver. In general, detected symbols are digitised complex numbers whose values are influenced both by intersymbol interference and noise introduced by the channel. On the other hand, an expected symbol is the anticipated value of the detected symbol taking into account intersymbol interference. In the absence of noise, the value of a detected symbol should coincide exactly with one of the expected symbols. It has to be noted that because the expected symbols are compensated for intersymbol interference they are dependant on the state at the previous time increment. At a given time increment k, each symbol type has an associated expected value for each state. The total number of expected symbols is thus given by the product of the number of states (x) and the number of symbols in the data alphabet. For a 2-symbol alphabet and a constraint length of 4 there are 16 states and hence 32 expected data symbol values.

A data symbol in the form of a complex number is regarded as a vector in signal space in which the real and imaginary parts are the components on the real and imaginary axes. In this case the branch metric b would be more fully expressed as follows :

$$b = \mid d_r - e_r \mid^2 + \mid d_i - e_i \mid^2$$

Where $d_r$ and $d_i$ are the real and imaginary components respectively of the detected symbol (D) and $e_r$ and $e_i$ are the real and imaginary components respectively of the expected symbol (E).

A drawback with calculating the true Euclidean distance is that it involves squaring, and since multiplication is computationally complex compared with addition, it requires relatively large and power consuming processing circuitry. In practice, however, this is not an overriding difficulty since a multiplication process is normally required in other parts of the equalizer, namely in conjunction with the matched filtering stage (i.e. matched to the channel input response) which ordinarily precedes the ML detector.

According to a first aspect of the present invention there is provided a method of estimating a data symbol in a sequence of transmitted data symbols which has become distorted by transmission through a dispersive communications channel, wherein a detected symbol (D) may differ from the expected symbol (E) and wherein a plurality of different states is associated with the transmission of said data symbols, which method includes the steps of determining for each state a value indicative of the relative probability of each state transition, and estimating the transmitted symbol based on the most likely state transition(s), characterized in that the value indicative of the relative probability of each state transition is defined by a pseudo-Euclidean metric (b) calculated using exclusively additive arithmetic.

The value of (b) in the present method, is not the true Euclidean distance as used in the prior art for calculating the branch metric, but is here regarded as 'pseudo-Euclidean'. That is to say, it is an approximation of the true Euclidean value. In accordance with the invention, however, this pseudo-Euclidean branch metric is calculated using only additive arithmetic. This is advantageous because additive arithmetic is far less complex than multiplication and so is less costly to implement, and it is significantly less power consuming.

The omission of multiplication for symbol estimation has important implications in the wider context of the overall equalization process, since the Applicants have found that the conventional matched filter stage can be dispensed with altogether without undue performance degradation. Consequently the equalization process can be effected without the use of any multiplication whatsoever. This dramatically reduces the implementation complexity of the equalizer which is an important factor for integrated circuit realization since it saves semiconductor area. Furthermore, the lack of a multiplier leads to a significant overall reduction in power consumption. In addition, omission of the matched filter enables the equaliser to operate faster.

Preferably, the pseudo-Euclidean metric (b) is defined by the formula

$$b = |d_r - e_r| + |d_i - e_i|$$

where $d_r$ and $d_i$ are the real and imaginary components respectively of the detected symbol (D) and $e_r$ and $e_i$ are the real and imaginary components respectively of the expected symbol (E).

According to a further aspect of the present invention there is provided an arrangement for estimating a data symbol in a sequence of transmitted data symbols which has become distorted by transmission through a dispersive communications channel, wherein a detected symbol (D) may differ from the expected symbol (E) and wherein a plurality of different states is associated with the transmission of said data symbols, including means for determining for each state a value indicative of the relative probability of each state transition, and means for estimating the transmitted symbol based on the most likely state transition(s), characterized in that the value indicative of the relative probability of each state transition is defined by a pseudo-Euclidean metric (b) calculated using exclusively additive arithmetic.

For the avoidance of doubt, the term additive arithmetic as used herein includes the process of subtraction, as is usual.

An embodiment of the invention will now be described, by way of example, with reference to the accompanying drawings, in which :

Figure 1 is a part of a 16-state trellis diagram illustrating the possible state transitions,

Figure 2 is a schematic diagram showing an arrangement for estimating a data symbol,

Figure 3 is a schematic diagram of an arrangement for calculating the pseudo-Euclidean branch metric in accordance with the invention, and

Figure 4 is a schematic diagram of an equalizing arrangement in accordance with the invention.

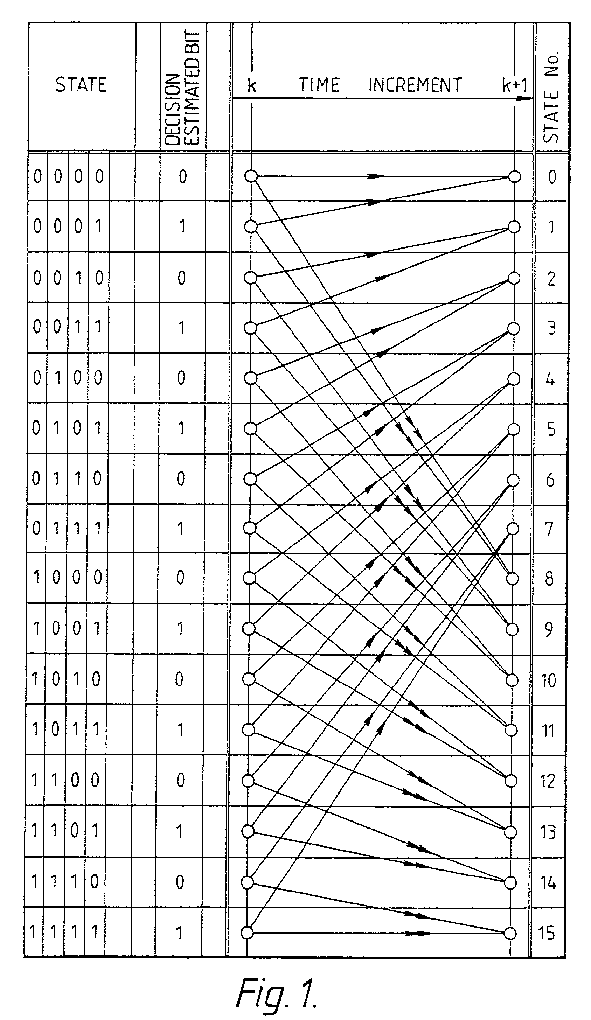

Figure 1 is a part of a trellis diagram for the 16 states associated with a 2-symbol alphabet in the case where the constraint length is 4. The two symbols may, for example, be + 1 and -1 mapped from the single bits 1 and 0 respectively. The states (0000, 0001 ...1110, 1111) are shown in the left hand (first) column and the decision estimated bit (i.e. the least significant bit) is shown in the column to the right of its respective state. The partial trellis diagram itself shows the state transitions for all 16 states at a time k and an incremented time k + 1. The time interval between k and k + 1 corresponds to the time interval between successive transmitted data symbols. Transitions with a single arrowhead represent a 0 transition bit, whereas transitions with a double arrowhead represent a 1 transition bit. By way of explanation, a state transition occurs as a result, of adding the transition bit to the current state in the position of the most significant bit and disregarding the least significant bit (i.e. the decision estimated bit) of the current state. The number of the state (0-15) is shown to the right of the trellis diagram.

In words, the partial path metric for any particular state 0 to 15 at time k + 1 is given by the sum of the partial path metric at time k plus the branch metric between k and k + 1. Expressed more mathematically in general terms :

$$M(x_{k+1},k + 1) = M(x_k,k) + b(x_{k+1},k + 1 \mid x_k,k)$$

where M is the partial path metric, b is the branch metric, x is the state number, and k is the time index. Hence $M(x,k + 1)$ is the partial path metric at state number $x_{k+1}$ at time k + 1 ; $M(x,k)$ is the partial path metric at state number $x_k$ at time k ; and $b(x,k + 1 \mid x,k)$ is the branch metric at state number $x_{k+1}$ at time k + 1 given the state number $x_k$ at time k.

The manner in which the individual branch metrics is calculated in accordance with the present invention is explained below.

It can be seen from the trellis diagram that for each state at time k + 1 there are two possible state transitions leading to that state. For each state one of these transitions corresponds to the transmission of one of the data symbols and the other transition corresponds to the transmission of the other data symbol. For the sake of generality these two symbols will now be referred to as A and B respectively, where A and B represents any binary alphabet mapped from the bits 0 and 1 respectively.

The partial path metrics can now be expressed more accurately for the two possible state transitions in the following general terms.

1) $M_A(x,k + 1) = M(x_A,k) + b(x,k + 1 \mid x_A,k)$ for symbol A ; and

2) $M_B(x,k + 1) = M(x_B,k) + b(x,k + 1 \mid x_B,k)$ for symbol B.

Considering state number 0 at time k + 1 and using the notation established above the respective partial path metrics of the two possible state transitions are given by :

1) $M_A(0,k + 1) = M(0,k) + b(0,k + 1 \mid 0,k)$ for symbol A ; and

2) $M_B(0,k + 1) = M(1,k) + b(0,k + 1 \mid 1,k)$ for symbol B.

Likewise at state number 1, the two partial path metrics corresponding to a transmitted A and B symbol are :

1) $M_A(1,k + 1) = M(2,k) + b(1,k + 1 \mid 2,k)$ for symbol A ; and

2) $M_B(1,k + 1) = M(3,k) + b(1,k + 1 \mid 3,k)$ for symbol B.

.... and so on until for example at state number 8 the situation is :

1) $M_A(8,k + 1) = M(0,k) + b(8,k + 1 \mid 0,k)$ for symbol A ; and

2) $M_B(8,k + 1) = M(1,k) + b(8,k + 1 \mid 1,k)$ for symbol B.

At the last state number 15 the corresponding equations are :

1) $M_A(15,k + 1) = M(14,k) + b(15,k + 1 \mid 14,k)$ for symbol A ; and

2) $M_B(15,k + 1) = M(15,k) + b(15,k + 1 \mid 15,k)$ for symbol B.

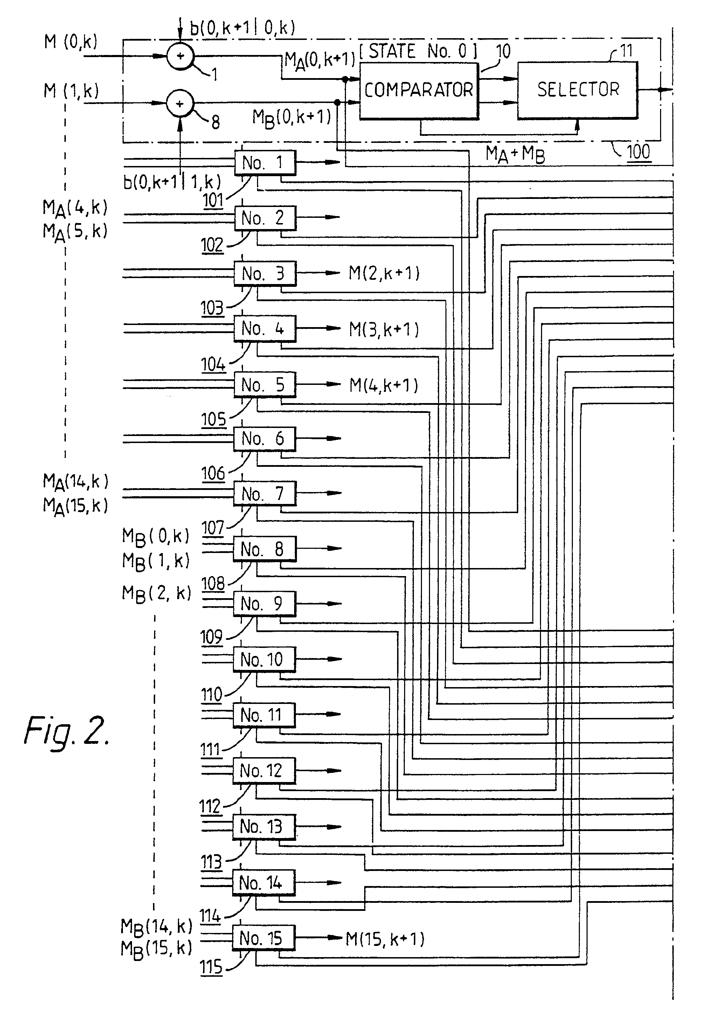

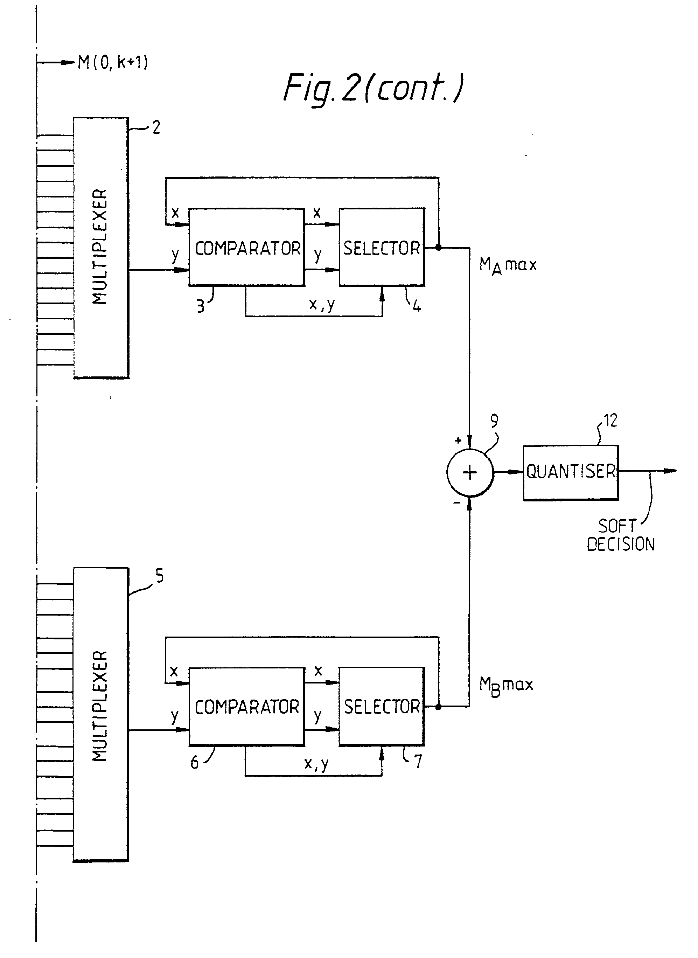

The arrangement in Figure 2 shows how the partial path metric information is processed to derive an almost immediate estimate of the current data symbol at time k + 1.

Firstly consider state number 0. The value of the partial path metric $M(0,k)$ is input into an adder 1 and the value of the branch metric $b(0,k + 1 \mid 0,k)$ is input into the same adder 1. The two values are summed to give the partial path metric $M_A(0,k + 1)$ corresponding to the transmission of a symbol A. The value of $M_A(0,k + 1)$ is input to a multiplexer 2. Fifteen other inputs from processing blocks 101-115 respectively are likewise input to the multiplexer 2, in the following order $M_A(1,k + 1)$, $M_A(2,k + 1)$....$M_A(15,k + 1)$ being the values of the partial path metrics at each of the fifteen remaining states numbered 1 to 15 respectively and corresponding to the transmission of a transmitted data symbol A. The processing blocks 101-115 for states 1 to 15 respectively are all functionally equivalent to the processing block 100 for state 0, shown bounded by a chain line in Figure 2. Under the control of a clock (not shown) the multiplexer transmits each of the partial path metric input values as a first input y to a comparator 3. The second input x to the comparator may initially be set at 0. The comparator indicates which is the larger of the two values x and y and the subsequent selector stage 4 selects the larger of the two values and feeds it back to the input x of comparator 3. The input x thus remains constant unless the input at y is greater in which case the input x assumes the higher value. Having compared all 16 partial path metrics the selector outputs the maximum value of the partial path metric for the symbol A over all sixteen states. This value is represented as $M_{Amax}$.

In an exactly analogous manner a separate arrangement of a multiplexer 5, comparator 6 and selector 7 are used to determine the maximum value of the partial path metrics for the B symbol over all sixteen states. Thus the multiplexer 5 has sixteen inputs, viz. $M_B(0,k + 1)$....$M_B(15,k + 1)$ being the values of the partial path metrics at each of the sixteen states respectively and corresponding to the transmission of a data symbol B.

The drawing shows how the value $M_B(0,k + 1)$ is determined at adder 8 by summing the value of the partial path metric $M(1,k)$ and the value of the branch metric $b(0,k + 1 \mid 1,k)$ in accordance with the equation given above. The equivalent process is carried out at each of the fifteen remaining states to determine the respective partial path metric for the B symbol. The comparator 6 and selector 7 are effective to output the maximum value of the partial path metric for the symbol B over all sixteen states. This value is represented as $M_{Bmax}$. The value $M_{Amax}$ from selector 4 is fed to an adder 9. The value $M_{Bmax}$ is inverted (made negative) and also fed to the adder 9 which thus combines the two input values to give the difference $M_{Amax} - M_{Bmax}$. This is an immediate estimate of the currently observed data symbol in the form of a soft decision. Entirely by way of example, the Applicants have used a quantiser 12 to quantise the estimated data symbols into eight levels.

The output from the quantiser 12 in this case is a sequence of three bits where 000 represents a first transmitted data symbol of the binary pair (i.e. A or -1) with maximum certainty, 0001 represents the same data symbol with less certainty, 0010 represents the same data symbol with even less certainty and 0011 represents the same data symbol with minimum certainty. On the other hand 111 represents the other symbol of the binary pair (hence B or +1) and 110, 101, and 100 represent the same symbol with gradually decreasing certainty.

It is noted that, depending on the internal arithmetic precision, the output from the adder 9 may already be quantized at the desired number of levels, in which case the quantiser 12 can be dispensed with.

So far the description has been limited to the estimation of an individual data symbol. However, the same basic scheme can be repeated at the same rate as the data symbol transmission rate to estimate the entire sequence of transmitted symbols. Such a process is generally known in the art as signal equalization.

To this end the arrangement shown in Figure 2 includes additional stages to those already described as follows.

For each state 0 to 15 a further comparator 10 and selector 11 are provided within the respective processing blocks 100-115. (For the sake of clarity in Figure 2 the comparator 10 and selector 11 are actually shown only in the processing block 100, but the other processing blocks 101-115 correspond). Each comparator compares the two respective inputs at a given time, say k + 1, corresponding to the partial path metrics corresponding to the transmission of an A and B symbol respectively. Thus as shown in Figure 2 for state number 0, the output $M_A(0,k + 1)$ from adder 1 and the output $M_B(0,k + 1)$ from adder 8 are applied to the comparator 10 and selector 11 which gives an output $M(0,k + 1)$ corresponding to the maximum value of this pair of partial path metrics. This indicates the maximum likelihood path to the current state, so that the other path can be discarded. This information is used to estimate the transmitted data signal at the next successive increment k + 2 when, in order to proceed along the trellis, it is necessary to know the partial path metric for each state at time k + 1. Thus this same comparison and selection process is carried out in parallel for each of the sixteen states at each time increment.

In the case of convolutional channel code introduced for the purpose of error correction, the full sequence of estimated data symbols would be further processed by a decoder (not shown) which is well-known in the art. The availability of soft decisions at the decoder input enables the overall bit error performance to be improved compared with hard decisions, since the decoder is able to utilize the certainty information in arriving at a final more accurate decision.

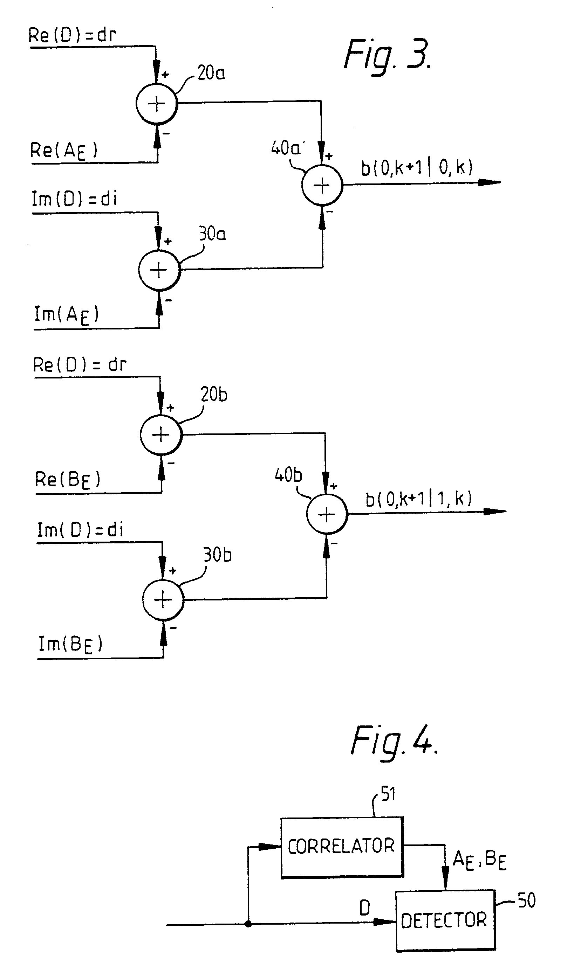

Figure 3 shows an arrangement for calculating the pseudo-Euclidean branch metrics using only additive arithmetic in accordance with the invention. As explained above, by pseudo-Euclidean is meant an approximation of the true Euclidean distance between the detected symbol **(D)** and the expected symbol **(E)**. As is conventional the branch metric is an indication of the relative probability of a particular transition.

The arrangement in Figure 3 is for calculating the pseudo-Euclidean branch metric (b) defined generally by the formula $b = |d_r - e_r| + |d_i - e_i|$ where $d_r$ and $d_i$ are the real and imaginary components respectively of the detected symbol **(D)** and $e_r$ and $e_i$ are the real and imaginary components respectively of the expected symbol **(E)**.

In the present example we consider a binary alphabet comprising the two symbols A and B. In the general case, each of these symbols has a real part and an imaginary part. Furthermore for each symbol there can be calculated an expected value of the symbol, here designated by $A_E$ and $B_E$ respectively. Again, each of these expected symbols has real parts, designated here as $Re(A_E)$, $Re(B_E)$, respectively ; and imaginary parts designated $Im(A_E)$ and $Im(B_E)$ respectively. The calculation of the expected symbols is itself well-known in the art and will not be described further in the present context, except to say that the expected symbol is the form in which a particular transmitted symbol is expected to be observed or detected after transmission through the channel taking into account the channel input response. There is of course for each state x an expected symbol for each symbol of the data alphabet being used. These expected symbols $(A_{E1}, B_{E1} ; A_{E2}, B_{E2} ; .....A_{Ex}, B_{Ex})$ may be stored in memory, for example, in the form of a look-up table for use in calculating the pseudo-Euclidean metric in the manner to be described.

Consider state x = 0 at time k + 1. There are two pseudo-Euclidean branch metrics to be calculated at this stage corresponding to the transmission of a symbol A and a symbol B respectively. The metric for the A symbol is calculated by differencing the real component $d_r$ (or Re**(D)**) of the detected symbol **D** and the real component $Re(A_{E0})$ of the expected symbol $A_{E0}$ at subtraction stage 20. Similarly the imaginary component $(Im(A_{E0}))$ of the expected symbol $A_{E0}$ is subtracted from the imaginary component of $d_i$ (or Im(D)) of the detected symbol at subtraction stage 30a. The results of these two subtractions are summed by adder 40a to output the pseudo-Euclidean branch metric $b(0,k + 1|0,k)$ which is input to the adder 1 in block 100 as already described above with reference to Figure 2. The pseudo-Euclidean branch metric $b(0,k + 1|0,k)$ has thus been calculated in accordance with the formula

$$b(0,k + 1|0,k) = |Re(D - A_{E0})| + |Im(D - A_{E0})|$$

In parallel with the calculation just described the pseudo-Euclidean branch metric is likewise calculated for the B symbol. Thus the real component $Re(B_{E0})$ of the expected symbol $B_{E0}$ is subtracted from the real component $d_r$ (or $Re(D)$) of the detected symbol D at subtraction stage 20b. Similarly the imaginary component $(Im(B_{E0}))$ of the expected symbol $B_{E0}$ is subtracted from the imaginary component $(Im(D))$ of the detected symbol at subtraction stage 30b. The results of these two subtractions are summed by adder 40b to output the pseudo-Euclidean branch metric $b(0,k + 1 \mid 1,k)$ which is input to the adder 8 in block 100 as already described above with reference to Figure 2.

The pseudo-Euclidean branch metric $b(0,k + 1 \mid 1,k)$ has thus been calculated in accordance with the formula

$$b(0,k + 1 \mid 1,k) = \mid Re(D - B_{E0}) \mid + \mid Im(D - B_{E0}) \mid$$

The arrangement shown in Figure 2 is used to calculate the two pseudo-Euclidean branch metrics associated with state number 0 only. The same functional arrangement is thus repeated a further fifteen times, once for each of the other fifteen states 1 to 15 so that the respective associated pairs of branch metrics $b(1,k + 1 \mid 2,k)$, $b(1,k + 1 \mid 3,k)$ ; .... $b(15,k + 1 \mid 14k)$, $b(15k + 1 \mid 15k)$.

The thirty-two branch metrics remain constant throughout the trellis. They can therefore be calculated at the outset and stored, e.g. in a random access memory for use throughout the calculations involved in the Viterbi algorithm.

Figure 4 illustrates an arrangement for equalizing a data signal comprising a detector 50 which operates as described with reference to Figures 2 and 3. The detected symbol D is input directly to the detector 50 without the usual matched filter stage. The expected symbols $A_{Ex}$, $B_{Ex}$ are determined in known manner as discussed above, for example at a correlator 51. The expected symbols $A_{Ex}$, $B_{Ex}$ are then available for use by the detector 50 as described above. The Applicants have found that the omission of a matched filter before the detector results in only an acceptably small loss of overall performance using the configuration disclosed herein and this minimal loss of performance far outweighs the benefits gained.

In view of the foregoing description it will be evident to a person skilled in the art that various modifications may be made within the scope of the invention. In particular the pseudo-Euclidean metric b is not restricted to the specific approximation $b = \mid d_r - e_r \mid + \mid d_i - e_i \mid$, but any close approximation of the true Euclidean distance may equally be employed provided that it is calculated without requiring multiplication, i.e. using exclusively additive arithmetic. Also, it is noted that although the above description has concentrated on a binary data alphabet, the present invention is equally applicable to alphabets comprising more than two symbols. In this case the set of symbols may always be divided and re-divided symmetrically into sub-sets of symbols until there is ultimately a plurality of sub-sets each comprising only two symbols and the method disclosed herein is then applied in respect of each such sub-set of two symbols as it applies to the two symbols (A and B) constituting a binary alphabet within that sub-set.

## Claims

1. A method of estimating a data symbol in a sequence of transmitted data symbols which has become distorted by transmission through a dispersive communications channel, wherein a detected symbol (D) may differ from the expected symbol (E) and wherein a plurality of different states is associated with the transmission of said data symbols, which method includes the steps of determining for each state a value indicative of the relative probability of each state transition, and
estimating the transmitted symbol based on the most likely state transition(s),
characterized in that the value indicative of the relative probability of each state transition is defined by a pseudo-Euclidean metric (b) calculated using exclusively additive arithmetic.

2. A method as claimed in claim 1, wherein the pseudo-Euclidean metric (b) is defined by the formula
$$b = \mid d_r - e_r \mid + \mid d_i - e_i \mid$$
where $d_r$ and $d_i$ are the real and imaginary components respectively of the detected symbol (D) and $e_r$ and $e_i$ are the real and imaginary components respectively of the expected symbol (E).

3. An arrangement for estimating a data symbol in a sequence of transmitted data symbols which has become distorted by transmission through a dispersive communications channel, wherein a detected symbol (D) may differ from the expected symbol (E) and wherein a plurality of different states is associated with the transmission of said data symbols, including
means for determining for each state a value indicative of the relative probability of each state transition, and
means for estimating the transmitted symbol based on the most likely state transition(s),
characterized in that the value indicative of the relative probability of each state transition is defined by a pseudo-Euclidean metric (b) calculated using exclusively additive arithmetic.

4. An arrangement as claimed in claim 3, including means for calculating the pseudo-Euclidean metric (b) according to the formula

$$b = |d_r - e_r| + |d_i - e_i|$$

where $d_r$ and $d_i$ are the real and imaginary components respectively of the detected symbol **(D)** and $e_r$ and $e_i$ are the real and imaginary components respectively of the expected symbol **(E).**

5. An arrangement for equalizing a data signal, comprising an arrangement for estimating, a data symbol as claimed in claim 3 or claim 4, and further including means for determining the expected symbol for each of the symbols in the data alphabet used.

*Fig. 1.*

*Fig. 2.*

→ M(0, k+1)

## Fig.2(cont.)

Re(D) = dr

+ 20a

Re(A_E) −

40a' +

b(0,k+1 | 0, k)

Im(D) = di

+ 30a

Im(A_E) −

*Fig. 3.*

Re(D) = dr

+ 20b

Re(B_E) −

40b +

b(0,k+1 | 1, k)

Im(D) = di

+ 30b

Im(B_E) −

*Fig. 4.*

51

CORRELATOR

A_E, B_E

D

DETECTOR 50